# EUROPEAN PATENT APPLICATION

(11) **EP 2 546 884 A1**
(43) Date of publication of application: **16.01.2013**
(21) Application number: 11753439.6
(22) Date of filing: 10.03.2011
(51) Int. Cl.: H01L 29/786, G02F 1/1368, H01L 21/28, H01L 21/336

(54) **SEMICONDUCTOR DEVICE AND METHOD FOR MANUFACTURING THE SAME**

(30) Priority: 11.03.2010 JP 2010054617
(71) Applicant: Sharp Kabushiki Kaisha, Osaka-shi, Osaka 545-8522 (JP)
(72) Inventor: FUKAYA, Tetsuo, Osaka 545-8522 (JP)
(74) Representative: Müller - Hoffmann & Partner
(86) International application number: PCT/JP2011/055658
(87) International publication number: WO 2011/111781

(57) **Abstract**

A semiconductor device (**100**) according to the present invention includes: a substrate (**1**); a gate electrode (**11**) which is arranged on the substrate; a gate insulating layer (**12**) which has been formed on the gate electrode; an oxide semiconductor layer (**13**) which has been formed on the gate insulating layer and which includes a channel region (**13c**) and source and drain regions (**13s, 13d**) that interpose the channel region between them; a source electrode (**14**) which is electrically connected to the source region; a drain electrode (**15**) which is electrically connected to the drain region; and a metallic compound layer (**16**) which is arranged between the source and drain electrodes so as to be located on, and contact with, the oxide semiconductor layer. The metallic compound layer is an insulating layer or semiconductor layer which is made of a compound of the same metallic element as at least one of metallic elements that are included in the source and drain electrodes.

## Description

### TECHNICAL FIELD

The present invention relates to a semiconductor device and more particularly relates to a semiconductor device including an oxide semiconductor TFT. The present invention also relates to a method for fabricating such a semiconductor device.

### BACKGROUND ART

An active-matrix substrate for use in a liquid crystal display device and other devices includes switching elements such as thin-film transistors (which will be simply referred to herein as "TFTs"), each of which is provided for an associated one of pixels. As such switching elements, a TFT that uses an amorphous silicon film as its active layer (and will be referred to herein as an "amorphous silicon TFT") and a TFT that uses a polysilicon film as its active layer (and will be referred to herein as a "polysilicon TFT") have been used extensively.

In a polysilicon film, electrons and holes have higher mobility than in an amorphous silicon film. That is why a polysilicon TFT has a larger ON-state current, and can operate faster, than an amorphous silicon TFT. Consequently, if an active-matrix substrate is made using polysilicon TFTs, the polysilicon TFTs can be used not only as switching elements but also in a driver and other peripheral circuits as well. As a result, part or all of the driver and other peripheral circuits and the display section can be integrated together on the same substrate, which is beneficial. In addition, the pixel capacitor of a liquid crystal display device, for example, can be charged in a shorter switching time as well, which is also advantageous.

If a polysilicon TFT is to be fabricated, however, the process step of crystallizing an amorphous silicon film with a laser beam or heat, a thermal annealing process step, and other complicated process steps should be carried out, thus raising the manufacturing cost per unit area of the substrate. For that reason, polysilicon TFTs are currently used mostly in small- and middle-sized liquid crystal display devices.

Meanwhile, an amorphous silicon film can be formed more easily than a polysilicon film, and therefore, can be used more suitably to make a device with a huge area. That is why amorphous silicon TFTs can be used effectively to make an active-matrix substrate that needs a big display area. In spite of their smaller ON-state current than polysilicon TFTs, amorphous silicon TFTs are currently used in the active-matrix substrate of most LCD TVs.

Nevertheless, if amorphous silicon TFTs are used, the mobility of the amorphous silicon film is too low to enhance their performance unlimitedly. Generally speaking, a liquid crystal display device such as an LCD TV must realize not just a huge display screen but also much higher image quality and far lower power dissipation as well. For that reason, it should be difficult for an amorphous silicon TFT to meet all of these expectations fully. Also, recently, in order to make the frame area as narrow as possible and cut down the cost as much as one can, there have been increasing demands for further performance enhancement by either realizing driver-monolithic substrates or introducing a touchscreen panel function. However, it is difficult for an amorphous silicon TFT to meet these demands sufficiently.

Thus, to realize a TFT of even higher performance with the number of manufacturing processing steps and the manufacturing cost cut down, materials other than amorphous silicon and polysilicon have been tentatively used for the active layer of a TFT.

Patent Documents Nos. 1 and 2 propose making the active layer of a TFT of an oxide semiconductor film of zinc oxide, for example. Such a TFT will be referred to herein as an "oxide semiconductor TFT". An oxide semiconductor has higher mobility than amorphous silicon. That is why an oxide semiconductor TFT can operate faster than an amorphous silicon TFT. On top of that, an oxide semiconductor film can be formed through a simpler process than a polysilicon film, and therefore, can be used to make a device that should have a huge display area.

However, depending on the structure of the oxide semiconductor TFT, the oxide semiconductor film could be damaged so easily during the manufacturing process that the performance of the transistor could deteriorate eventually. For example, in an oxide semiconductor TFT with a bottom gate, top contact structure, when its source/drain electrodes are formed by patterning, a dry etching process is usually performed using a halogen gas such as a fluorine gas or a chlorine gas. In that case, however, the oxide semiconductor film will be exposed to halogen plasma, thus dissociating oxygen atoms from the oxide semiconductor film and causing some deterioration in performance (such as deterioration of the OFF-state characteristic due to a decrease in channel resistance).

Thus, to overcome such a problem, Patent Document Nos. 1 and 2 propose covering the channel region of an active layer made of an oxide semiconductor with an insulating film that functions as an etch stop layer (as a channel protective film).

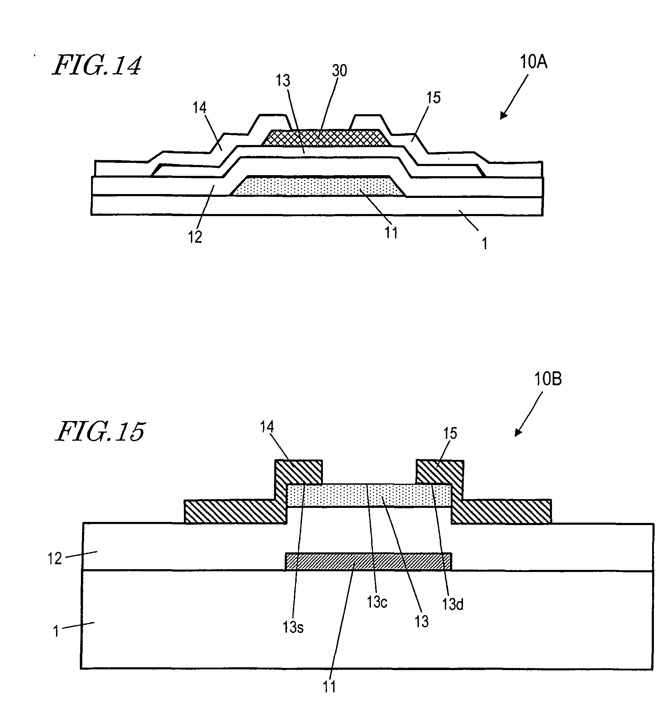

FIG. **14** illustrates a cross-sectional structure for a known oxide semiconductor TFT **10A** with such a channel protective film. The oxide semiconductor TFT **10A** includes a substrate **1,** a gate electrode **11** arranged on the substrate **1,** a gate insulating film **12** that covers the gate electrode **11,** an oxide semiconductor layer **13** deposited on the gate insulating film **12,** a channel protective film **30** that is arranged over the channel region of the oxide semiconductor layer **13,** and source/drain electrodes **14** and **15** arranged on the oxide semiconductor layer **13.** The source/drain electrodes **14** and **15** are electrically connected to the oxide semiconductor layer **13.** Patent Document No. 1 proposes using an amorphous oxide insulating film as the channel protective film **30.** On the other hand, Patent Document No. 2 proposes that a silicon nitride film be used as the channel protective film **30.**

In the process of fabricating an oxide semiconductor TFT **10A** such as the one shown in FIG. **14****,** when the source/drain electrodes **14** and **15** are formed by patterning a metal film, the channel region of the oxide semiconductor layer **13** is protected with the channel protective film **30.** Thus, it is possible to prevent the channel region of the oxide semiconductor layer **13** from getting damaged.

### CITATION LIST

### PATENT LITERATURE

Patent Document No. 1: Japanese Patent Application Laid-Open Publication No. 2008-166716
Patent Document No. 2: Japanese Laid-Open Patent Publication No. 2007-258675

### SUMMARY OF INVENTION

### TECHNICAL PROBLEM

In fabricating an oxide semiconductor TFT such as the ones disclosed in Patent Documents Nos. 1 and 2, however, the process step of patterning the channel protective film needs to be carried out. That is why compared to when a structure with no channel protective films is fabricated, the number of manufacturing process steps and the number of masks to use both increase. Consequently, the throughput decreases.

In order to overcome the problems described above, the present inventors perfected our invention for the purpose of minimizing the damage that could be done on the oxide semiconductor layer during the manufacturing process of such an oxide semiconductor TFT with a bottom gate, top contact structure and checking the decrease in throughput.

### SOLUTION TO PROBLEM

A semiconductor device according to the present invention includes: a substrate; a gate electrode which is arranged on the substrate; a gate insulating layer which has been formed on the gate electrode; an oxide semiconductor layer which has been formed on the gate insulating layer and which includes a channel region and source and drain regions that interpose the channel region between them; a source electrode which is electrically connected to the source region; a drain electrode which is electrically connected to the drain region; and a metallic compound layer which is arranged between the source and drain electrodes so as to be located on, and contact with, the oxide semiconductor layer. The metallic compound layer is an insulating layer or semiconductor layer which is made of a compound of the same metallic element as at least one of metallic elements that are included in the source and drain electrodes.

In one preferred embodiment, the metallic compound layer is thinner than the source and drain electrodes.

In one preferred embodiment, the metallic compound layer has a thickness of 1 nm to 50 nm.

In one preferred embodiment, the metallic compound layer has a thickness of 1 nm to 5 nm.

In one preferred embodiment, the metallic compound layer is a metal oxide layer.

A method for fabricating a semiconductor device according to the present invention includes the steps of: (A) forming a gate electrode on a substrate; (B) covering the gate electrode with a gate insulating layer; (C) forming an oxide semiconductor layer on the gate insulating layer; and (D) providing a source electrode and a drain electrode that are electrically connected to the oxide semiconductor layer. The step (D) includes the steps of: (D-1) forming a metal film over the oxide semiconductor layer; and (D-2) patterning the metal film, thereby forming the source and drain electrodes. The step (D-2) of patterning is performed so that a portion of the metal film that is located over a portion of the oxide semiconductor layer to be a channel region remains as a conductor film that is thinner than the source and drain electrodes. The method further includes the step (E) of forming a metallic compound layer between the source and drain electrodes by producing a chemical reaction in the conductor film.

In one preferred embodiment, the step (D-2) includes the steps of: (D-2-1) forming a photoresist layer which partially covers the metal film and which has a first portion that overlaps with parts of the oxide semiconductor layer to be source and drain regions; and (D-2-2) etching the metal film using the photoresist layer as a mask.

In one preferred embodiment, the step (D-2-1) is performed so that the photoresist layer has a second portion that overlaps with a part of the oxide semiconductor layer to be a channel region and that is thinner than the first portion.

In one preferred embodiment, the step (D-2-1) includes an exposure process step that uses a multi-tone mask.

In one preferred embodiment, the metallic compound layer formed in the step (E) is either an insulating layer or a semiconductor layer.

In one preferred embodiment, the metallic compound layer has a thickness of 1 nm to 50 nm.

In one preferred embodiment, the metallic compound layer has a thickness of 1 nm to 5 nm.

In one preferred embodiment, the step (E) includes forming a metal oxide layer as the metallic compound layer by oxidizing the conductor film.

### ADVANTAGEOUS EFFECTS OF INVENTION

The present invention can minimize the damage that could be done on an oxide semiconductor layer during the manufacturing process of an oxide semiconductor TFT with a bottom gate, top contact structure and can also check the decrease in throughput.

### BRIEF DESCRIPTION OF DRAWINGS

[FIG. **1**] A plan view schematically illustrating a TFT substrate **100** as a preferred embodiment of the present invention.
[FIG. 2] A cross-sectional view schematically illustrating a cross-sectional structure of the TFT substrate **100** as a preferred embodiment of the present invention as viewed on the plane **2A-2A'** shown in FIG. **1****.**
[FIG. 3] A cross-sectional view schematically illustrating a thin-film transistor **10** included in the TFT substrate **100** as a preferred embodiment of the present invention.
[FIG. **4****] (a)** to **(d)** are cross-sectional views illustrating respective manufacturing process steps to fabricate the TFT substrate **100.**
[FIG. **5**] **(a)** to **(d)** are cross-sectional views illustrating respective manufacturing process steps to fabricate the TFT substrate 100.
[FIG. **6**] **(a)** and **(b)** are cross-sectional views illustrating respective manufacturing process steps to fabricate the TFT substrate **100.**
[FIG. **7**] A graph showing the gate voltage-drain current (Vg-Id) characteristic of a thin-film transistor **10B** representing a comparative example.
[FIG. **8**] A graph showing the gate voltage-drain current (Vg-Id) characteristic of a thin-film transistor **10** representing Example #1.
[FIG. **9**] A graph showing the gate voltage-drain current (Vg-Id) characteristic of a thin-film transistor **10** representing Example #2.
[FIG. **10**] A graph showing the gate voltage-drain current (Vg-Id) characteristic of a thin-film transistor **10** representing Example #1.
[FIG. **11****]** A graph showing the gate voltage-drain current (Vg-Id) characteristic of a thin-film transistor **10** representing Example #2.
[FIG. **12**] A cross-sectional view schematically illustrating a TFT substrate **100** as a preferred embodiment of the present invention.
[FIG. **13**] A diagram illustrating an example in which the manufacturing process of the TFT substrate **100** as a preferred embodiment of the present invention is carried out as a four-mask process.
[FIG. **14**] A cross-sectional view schematically illustrating a known oxide semiconductor TFT **10A** with a channel protective film.
[FIG. **15**] A cross-sectional view schematically illustrating a known oxide semiconductor TFT **10B** with no channel protective film.

### DESCRIPTION OF EMBODIMENTS

Hereinafter, embodiments of the present invention will be described with reference to the accompanying drawings. A semiconductor device according to the present invention includes a thin-film transistor with an active layer made of an oxide semiconductor (which will be referred to herein as an "oxide semiconductor TFT"). A semiconductor device according to the present invention just needs to include at least one such oxide semiconductor TFT and may be implemented as any of various substrates, display devices and other electronic devices that use such TFTs. In the following description, the semiconductor device of the present inventions is supposed to be implemented as an active-matrix substrate (TFT substrate) for a liquid crystal display device.

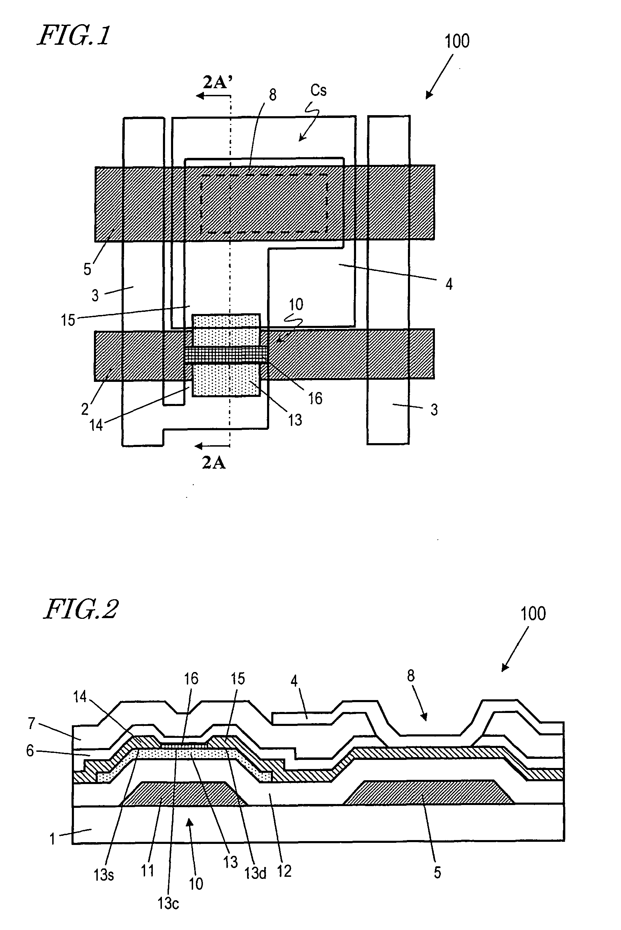

FIGS. **1** and **2** illustrate a TFT substrate **100** as an embodiment of the present invention. Specifically, FIG. **1** is a plan view schematically illustrating a portion of the TFT substrate **100** that is allocated to one pixel. FIG. **2** is a cross-sectional view thereof as viewed on the plane **2A-2A'** shown in FIG. **1****.**

As shown in FIGS. **1** and **2****,** the TFT substrate **100** includes a substrate **1** with an electrically insulating property (which is typically a transparent substrate), a gate line (scan line) **2** and a source line (signal line) **3** which are arranged on the substrate **1,** a thin-film transistor **10** which is electrically connected to the gate line **2** and the source line **3,** and a pixel electrode **4** which is electrically connected to the thin-film transistor **10.** The gate line **2** is arranged to run in the row direction, while the source line **3** is arranged to run in the column direction. The thin-film transistor **10** is supplied with a scan signal through the gate line **2** and also supplied with a display signal through the source line **3.** The TFT substrate **100** further includes a storage capacitor line **5** that forms part of a storage capacitor **Cs.**

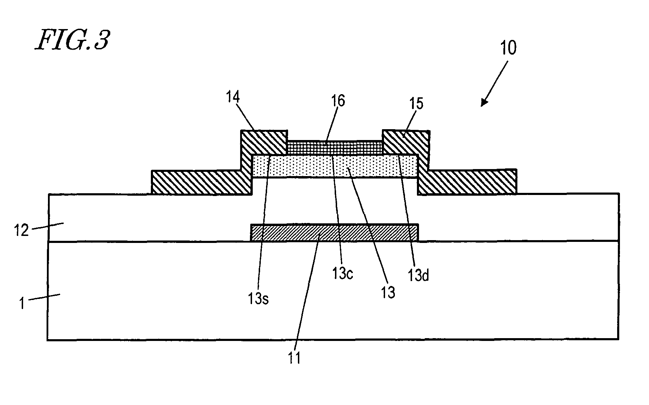

Hereinafter, the structure of the thin-film transistor **10** will be described in detail with reference to FIG. **3****,** too, which is a cross-sectional view schematically illustrating the thin-film transistor **10** on a larger scale.

The thin-film transistor **10** includes a gate electrode **11** which is arranged on a substrate **1,** a gate insulating layer **12** which has been formed on the gate electrode **11,** an oxide semiconductor layer **13** which has been formed on the gate insulating layer **12,** and source and drain electrodes **14** and **15** which are electrically connected to the oxide semiconductor layer **13.**

The source and drain electrodes **14** and **15** each contact with the upper surface of the oxide semiconductor layer **13.** A portion **13s** of the oxide semiconductor layer **13** that contacts with the source electrode **14** will be referred to herein as a "source region". Another portion **13d** of the oxide semiconductor layer **13** that contacts with the drain electrode **15** will be referred to herein as a "drain region". Still another portion **13c** of the oxide semiconductor layer **13** that overlaps with the gate electrode **11** and that is located between the source region **13s** and the drain region **13d** will be referred to herein as a "channel region". In other words, the oxide semiconductor layer **13** includes the channel region **13c** and the source and drain regions **13s** and **13d** that interpose the channel region **13c** between them. And the source and drain electrodes **14** and **15** are respectively electrically connected to the source and drain regions **13s** and **13d** of the oxide semiconductor layer **13.**

As shown in FIGS. **2** and **3****,** the thin-film transistor **10** of this embodiment further includes a metallic compound layer **16** which is arranged between the source and drain electrodes **14** and **15** so as to be located over, and contact with, the oxide semiconductor layer **13.** This metallic compound layer **16** is either an insulating layer or a semiconductor layer.

The metallic compound layer **16** has been formed by processing a portion of a metal film to be source and drain electrodes **14** and **15** (such a film will be referred to herein as a "source metal film"). Specifically, the metallic compound layer **16** is formed by intentionally leaving a portion of the source metal film, which is being patterned to define the source and drain electrodes **14** and **15,** over the channel region and then by turning that remaining portion (which naturally forms part of a conductor film) into a non-conductor by producing a chemical reaction in that portion. That is why the metallic compound layer **16** is made of a compound of the same metallic element as at least one (not necessarily every one as will be described later) of (one or) multiple different metallic elements that are included in the source and drain electrodes **14** and **15.**

As shown in FIG. **2****,** first and second interlayer insulating layers **6** and **7** have been deposited to cover the thin-film transistor **100** with such a structure. The first and second interlayer insulating layers **6** and **7** are stacked in this order and the pixel electrode **4** is arranged on the second interlayer insulating layer **7.**

A hole **8** has been cut through the first and second interlayer insulating layers **6** and **7** so as to be located right over the storage capacitor line **5.** The drain electrode **15** has been extended to reach that hole **8** and the pixel electrode **4** is connected to the drain electrode **15** in that hole **8.**

As described above, the TFT substrate **100** of this embodiment includes the metallic compound layer **16** between the source and drain electrodes **14** and **15** (i.e., over the channel region **13c** of the oxide semiconductor layer **13**). That is why when the source and drain electrodes **14** and **15** are formed by patterning (e.g., by dry etching), the portion of the source metal film to be the metallic compound layer **16** protects the oxide semiconductor layer **13.** As a result, damage that could be done on the oxide semiconductor layer **13** during the manufacturing process can be reduced. In addition, since the metallic compound layer **16** can be formed without depositing or patterning any additional film, the throughput increases compared to the structure with the channel protective film **30** such as the one shown in FIG. **14****.**

As shown in FIGS. **2** and **3****,** it is recommended that the metallic compound layer **16** is thinner than the source and drain electrodes **14** and **15.** The reason is that if the metallic compound layer **16** is thinner than the source and drain electrodes **14** and **15,** it is easier to avoid leaving any conductor portion when the metallic compound layer **16** is formed by producing a chemical reaction in the source metal film.

The source and drain electrodes **14** and **15** typically have a thickness of 100 nm to 500 nm. On the other hand, the metallic compound layer **16** suitably has a thickness of 1 nm to 50 nm for the following reasons. Specifically, if the thickness of the metallic compound layer **16** were more than 50 nm, it could be difficult to avoid leaving the conductor portion depending on the kind of the chemical reaction to produce. Also, if the thickness of the metallic compound layer **16** were less than 1 nm, then the channel region **13c** could be exposed due to non-uniform etching. In that case, damage could be done on the oxide semiconductor layer **13.**

The metallic compound layer **16** may be made of any compound as long as the compound is either an insulator or a semiconductor. For example, if the metallic compound layer **16** is a metal oxide layer made of a metal oxide, even an oxygen deficiency produced in the oxide semiconductor layer **13** can be made up for with oxygen included in the metal oxide layer. As a result, the oxygen deficiency of the oxide semiconductor layer **13** can be reduced significantly.

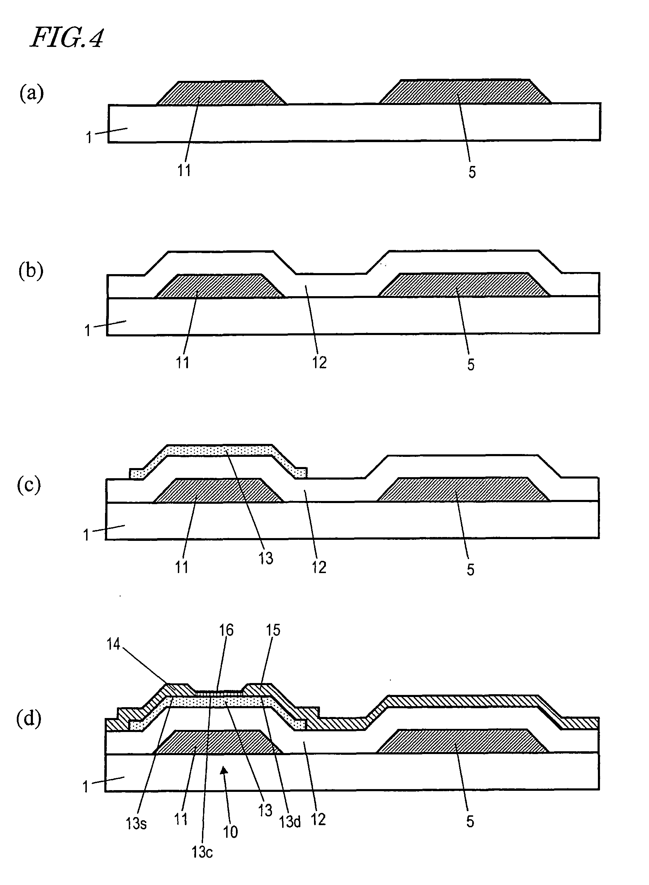

Hereinafter, an exemplary method for fabricating the TFT substrate **100** will be described with reference to FIGS. **4** through **6****,** which are cross-sectional views illustrating respective manufacturing process steps to fabricate the TFT substrate **100.**

First of all, as shown in FIG. **4(a)****,** a gate electrode **11** is formed on a substrate (such as a glass substrate) **1**. In this process step, a gate line **2** (not shown in FIG. **4(a)****)** and a storage capacitor line **5** are also formed. The gate electrode **11,** gate line **2** and storage capacitor line **5** may be formed by depositing a metal film (conductor film) on the substrate **1** by sputtering process, for example, and then by patterning the metal film by photolithographic process. As the metal film to be the gate electrode **11,** gate line **2** and storage capacitor line **5** (which will be referred to herein as a "gate metal film"), a Ti/Al/Ti film, an Al/Ti film or a Cu/Ti film may be used. The gate electrode **11,** gate line **2** and storage capacitor line **5** may have a thickness of 100 nm to 500 nm.

Next, as shown in FIG. **4(b)****,** a gate insulating layer **12** is deposited to cover the gate electrode **11** and other members. The gate insulating layer **12** may be deposited by CVD process, for example. As the gate insulating layer **12,** an SiO₂ film, an SiNₓ film or their stack may be used. If an oxide film such as an SiO₂ film is used as the gate insulating layer **12,** the oxygen deficiency of the oxide semiconductor layer **13** can be minimized, which is beneficial. Also, if the gate insulating layer **12** is a multilayer film, then the same advantage can be achieved by stacking those films one upon the other in such an order that an oxide film contacts with the oxide semiconductor layer **13.** The gate insulating layer **12** may have a thickness of 200 nm to 500 nm, for example.

Subsequently, as shown in FIG. **4(c)****,** an oxide semiconductor layer **13** is formed on the gate insulating layer **12.** The oxide semiconductor layer **13** is typically made of an amorphous oxide. Examples of materials for the oxide semiconductor layer **13** include a Zn-O based semiconductor (which will be referred to herein as "ZnO"), an In-Ga-Zn-O based semiconductor (which will be referred to herein as "IGZO"), an In-Zn-O based semiconductor (which will be referred to herein as "IZO") and a Zn-Ti-O based semiconductor (which will be referred to herein as "ZTO").

Specifically, the oxide semiconductor layer **13** may be formed in the following manner. First of all, an IGZO film is deposited by sputtering process to a thickness of 30 nm to 300 nm on the gate insulating layer **12.** Next, a photoresist layer is formed by photolithographic process so as to cover a predetermined region of the IGZO film. Then, exposed portions of the IGZO film, which are not covered with the photoresist layer, are wet-etched away, and then the photoresist layer is stripped. In this manner, islands of the oxide semiconductor layer 13 can be obtained.

Thereafter, as shown in FIG. 4(d), source and drain electrodes 14 and 15, which are electrically connected to the oxide semiconductor layer 13, are provided and then the metallic compound layer 16 is defined between the source and drain electrodes **14** and **15.** Hereinafter, these processing steps will be described in further detail.

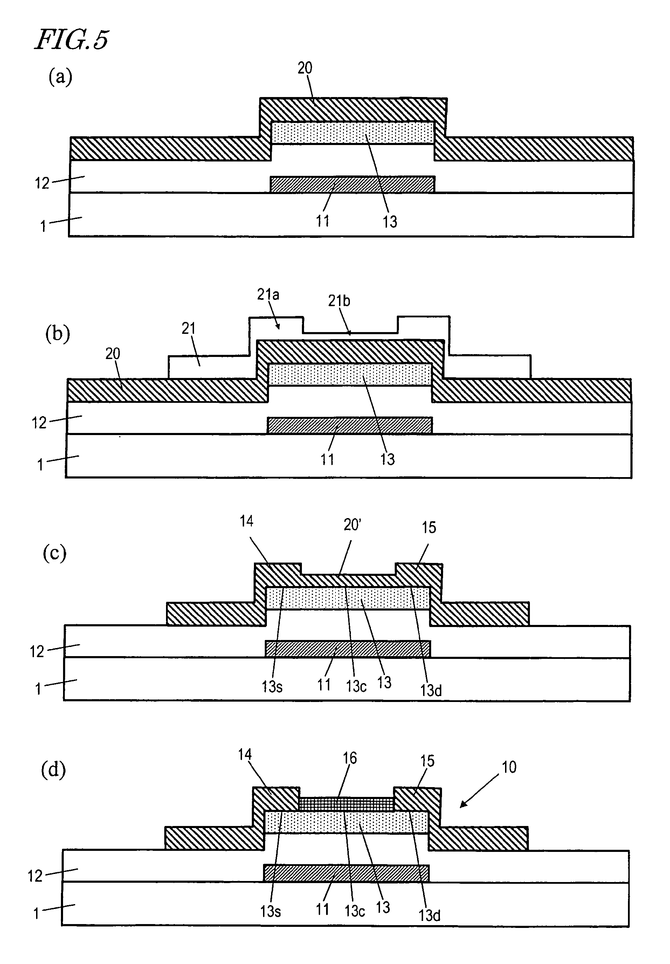

First, as shown in FIG. **5(a)****,** a metal film (source metal film) **20** is deposited over the oxide semiconductor layer **13.** The metal film **20** may be deposited by sputtering process, for example. As the metal film **20,** a Ti/Al/Ti film, an Al/Ti film, a Cu/Ti film, an Al film, a Cu film or an Mo film may be used. The metal film **20** may have a thickness of 100 nm to 500 nm, for example.

Next, source and drain electrodes **14** and **15** are formed by patterning the metal film **20.** In this process step, a source line **3** is also formed. This patterning process step is carried out so that a portion of the metal film **20** which is located over a part of the oxide semiconductor layer **13** to define a channel region, remains as a thinner conductor film than the source and drain electrodes **14** and **15** are.

Specifically, first, as shown in FIG. **5(b)****,** a photoresist layer **21** is formed so as to selectively cover the metal film **20.** This photoresist layer **21** has a first portion **21a** that overlaps with portions of the oxide semiconductor layer **13** to define the source and drain regions **13s** and **13d** and a second portion **21b** that overlaps with a portion of the oxide semiconductor layer **13** to define the channel region **13c.** As shown in FIG. **5(b)****,** the second portion **21b** is thinner than the first portion **21a.** In other words, the photoresist layer **21** has a distribution in its thickness. Such a photoresist layer **21** can be obtained by performing an exposure process using a multi-tone mask. By performing a multi-tone exposure process using such a multi-tone mask, a portion subjected to a half-tone exposure process becomes the second portion **21b.** As the multi-tone mask, either a grey tone mask or a half-tone mask may be used, for example. The grey tone mask has a slit, of which the width is equal to or less than the resolution of the exposure system used. By partially cutting off the light using such a slit, a half-tone exposure process can be carried out. On the other hand, the half-tone mask realizes a half-tone exposure process by using a semi-transparent film.

Next, as shown in FIG. **5(c)****,** the metal film **20** is etched (e.g., dry-etched) using the photoresist layer **21** as a mask, thereby forming source and drain electrodes **14** and **15.** In this process step, a portion of the metal film **20** that is covered with the second portion **21b** (i.e., the thinner portion) of the photoresist layer **21** is lightly etched. As a result, a conductor film **20'** which is thinner than the source and drain electrodes **14** and **15** is left over the channel region **13c** of the oxide semiconductor layer **13.** That conductor film **20'** may have a thickness of 1 nm to 50 nm, for example.

Thereafter, as shown in FIG. **5(d)****,** a chemical reaction is produced in the conductor film **20',** thereby forming a metallic compound layer **16** between the source and drain electrodes **14** and **15.** For example, by oxidizing the conductor film **20',** a metal oxide layer is formed as the metallic compound layer **16.** If the metal film (i.e., source metal film) **20** is an Al film, a Cu film or an Mo film, then the metallic compound layer **16** will be an aluminum oxide layer, a copper dioxide layer, or a molybdenum oxide layer, respectively. On the other hand, if the metal film **20** is a multilayer film that uses a Ti film as its base layer such as a Ti/Al/Ti film, an Al/Ti film or a Cu/Ti film and if the etching process has been carried out so that the conductor film **20'** becomes a Ti film (i.e., so that only the base layer remains as the conductor film **20**'), then the metallic compound layer **16** becomes a titanium oxide layer. As can be seen, if the metal film (source metal film) **20** is a single-layer film, the metallic compound layer **16** is made of a compound of the same metallic element(s) as the metallic element(s) included in the source and drain electrodes **14** and **15.** On the other hand, if the metal film (source metal film) **20** is a multilayer film, then the metallic compound layer **16** may be made of a compound of the same metallic element(s) as a part of multiple different metallic elements included in the source and drain electrodes **14** and **15.** The oxidation can be done by any of various methods. For example, plasma of oxygen gas, nitrogen gas or laughing gas may be used. Or hydrogen peroxide water may be used. Alternatively, an anodic oxidation process may also be adopted. In this example, a metal oxide layer is supposed to be formed as the metallic compound layer **16** by oxidizing the conductor film **20'.** However, the metallic compound layer **16** may be made of any other compound as long as the compound is an insulator or a semiconductor. In this manner, a thin-film transistor **10** is obtained.

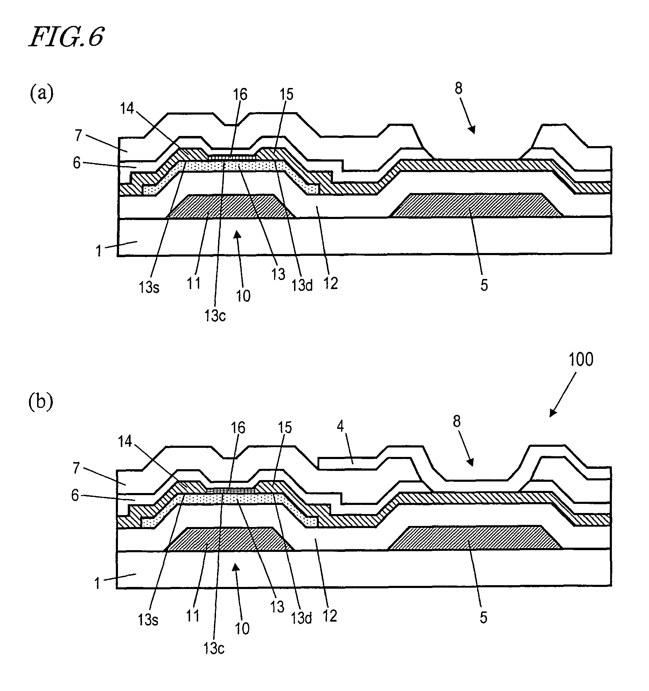

Next, as shown in FIG. **6(a)****,** first and second interlayer insulating layers **6** and **7** are deposited in this order so as to cover the thin-film transistor **10.** The first interlayer insulating layer **6** may be an SiO₂ film, an SiNₓ film, or a spin on glass (SOG) film, for example. The second interlayer insulating layer **7** may be an acrylate-based photosensitive resin film, for example. A hole **8** has been cut through the first and second interlayer insulating layers **6** and **7** to expose the surface of the drain electrode **15.** Although the metallic compound layer **16** and the first and second interlayer insulating layers **6** and **7** function as a protective layer that protects the thin-film transistor **10** in this embodiment, the protective layer does not have to be made up of three layers. For example, the thin-film transistor **10** can also be protected only with the metallic compound layer **16.**

Thereafter, as shown in FIG. **6(b)****,** a pixel electrode **4** is formed so as to contact with the exposed surface of the drain electrode **15.** The pixel electrode **4** may be formed by depositing a conductor film by sputtering over the second interlayer insulating layer **7** and inside the hole **8** and then patterning the conductor film by photolithographic process, for example. The pixel electrode **4** may be made of ITO, for example. In this manner, the TFT substrate **100** is completed.

According to the manufacturing process of this embodiment, in the process step of forming the source and drain electrodes **14** and **15** (i.e., the process step shown in FIG. **5(c)**), the oxide semiconductor layer **13** can be protected with the conductor film **20'** that is located over the channel region **13c,** and therefore, damage that could be done on the oxide semiconductor layer **13** can be reduced. In addition, since the conductor film **20'** forms part of the metal film (source metal film) to be the source and drain electrodes **14** and **15,** there is no need to deposit a new film to make the conductor film **20'.** That is why the manufacturing process of this embodiment has a lot of advantages over the manufacturing process that provides the channel protective film **30** as shown in FIG. **14****.** For instance, compared to a situation where the channel protective film **30** (of SiO₂, for example) is formed by sputtering, the throughput can be increased. Meanwhile, compared to a situation where the channel protective film **30** is formed by CVD process, there is no need to carry out a CVD process. On top of that, according to the manufacturing process of this embodiment, the number of masks to use may be the same as in a situation where a known channel etch structure (i.e., a structure that needs no channel protective film **30**) is fabricated. Consequently, the manufacturing process of this embodiment can be simpler than the manufacturing process that provides the channel protective film **30.** As a result, the throughput can be increased for this reason, too. Moreover, according to the manufacturing process of this embodiment, a wet etching process can also be adopted in the process step of forming the source and drain electrodes **14** and **15.** The reason is that as there is the conductor film **20',** the oxide semiconductor layer **13** will not be directly immersed in the etchant. For example, if the source metal film is a Cu/Ti film, the Cu film should be wet etched and then the Ti film should be dry-etched according to the known channel etch structure. However, according to the manufacturing process of this embodiment, the Cu/Ti films that form the source metal film (metal film) **20** can be wet-etched at a time.

The conductor film **20'** that protects the oxide semiconductor layer **13** will turn into the metallic compound layer **16,** which is either an insulating layer or a semiconductor layer, by going through a chemical reaction produced in a subsequent process step (i.e., the process step shown in FIG. **5(d)**). According to the manufacturing process of this embodiment, the process step of patterning the metal film **20** (i.e., the process step shown in FIG. **5(c)**) is carried out so that the conductor film **20'** becomes thinner than the source and drain electrodes **14** and **15.** That is why it is easy to leave no conductor portion at all when the metallic compound layer **16** is formed.

As described above, it is recommended that the metallic compound layer **16** (i.e., the conductor film **20')** has a thickness of 1 nm to 50 nm. And if the metallic compound layer **16** is a metal oxide layer, it would be more convenient for the reasons to be described below that the metallic compound layer **16** has a thickness of 1 nm to 5 nm.

Specifically, when the metal film **20** to be the source and drain electrodes **14** and **15** is formed (in the process step shown in FIG. **5(a)**), sometimes a reduction reaction may be produced in the oxide semiconductor layer **13** and some metal may be deposited in the channel region **13c.** And if a leakage path is made by that metal, the characteristic of the transistor could vary.

If the conductor film **20'** (i.e., the metallic compound layer **16)** has a thickness of 1 nm to 5 nm, then the oxide semiconductor layer **13** can get oxidized in the process step of oxidizing the conductor film **20'.** That is why it is possible to prevent that metal deposited in the channel region **13c** from making a leakage path. As a result, the variation in the characteristic of the transistor can be minimized.

Also, although not shown in any of the drawings, not only those oxide semiconductor TFTs **10** provided as switching elements for respective pixels (which will be referred to herein as "pixel TFTs") but also some or all of TFTs for drivers and other peripheral circuits (which will be referred to herein as "circuit TFTs") may be integrated together on the same TFT substrate **100** (to make a monolithic circuit). The peripheral circuits are arranged on an area (which is called a "frame area") of the TFT substrate other than another area thereof including pixels (which is called a "display area"). The oxide semiconductor TFTs use an oxide semiconductor layer that has high mobility (of 10 cm²/Vs or more, for example) as their active layer, and therefore, can be used as not only pixel TFTs but also circuit TFTs as well in such a situation.

### (EXAMPLES AND COMPARATIVE EXAMPLES)

The present inventors actually made a thin-film transistor **10** for the TFT substrate **100** of this embodiment and a thin-film transistor with a known structure as oxide semiconductor TFTs and measured their transistor characteristics. The results will be described below.

Specifically, as Examples #1 and #2, thin-film transistors **10** having the structure shown in FIG. **3** (i.e., with the metallic compound layer **16**) were made. The thin-film transistor **10** representing Example #1 had a metallic compound layer **16** with a thickness of more than 5 nm to 50 nm. On the other hand, the thin-film transistor **10** representing Example #2 had a metallic compound layer **16** with a thickness of 1 nm to 5 nm. Both of those transistors are fabricated by the method that has already been described with reference to FIG. **4** and other drawings.

Meanwhile, a thin-film transistor **10B** having the structure shown in FIG. **15** was also made as a comparative example. Unlike the thin-film transistors **10** and **10A** shown in FIGS. **3** and **14****,** the thin-film transistor **10B** had neither the metallic compound layer **16** nor the channel protective film **30.** Other than the metallic compound layer **16,** however, the thin-film transistors **10** as Examples #1 and #2 and the thin-film transistor **10B** as this comparative example were supposed to have the same configuration in terms of the materials, thicknesses and sizes of the respective layers.

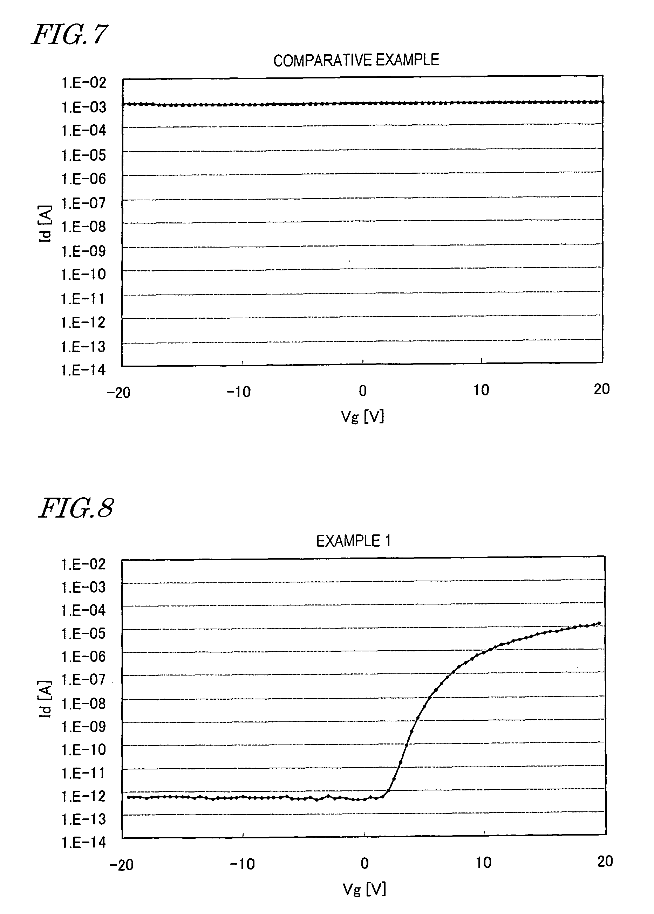

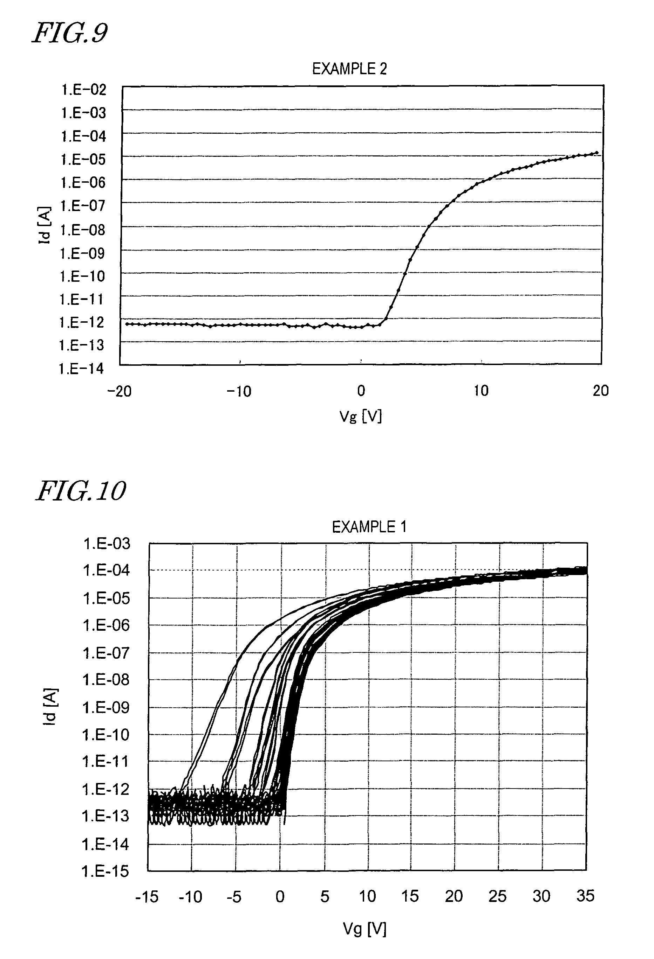

The present inventors measured the gate voltage-drain current (Vg-Id) characteristics of the thin-film transistors **10** as Examples #1 and #2 and the thin-film transistor **10B** as comparative example. The result of measurement obtained from the thin-film transistor **10B** representing the comparative example is shown in FIG. **7****.** On the other hand, the results of measurements obtained from the thin-film transistors **10** representing Examples #1 and #2 are shown in FIGS. **8** and **9****,** respectively.

As shown in FIG. **7****,** the thin-film transistor **10B** as comparative example had a substantially constant drain current irrespective of the magnitude of the gate voltage and did not exhibit the transistor characteristic (ON/OFF characteristic). This is probably because the oxide semiconductor layer **13** would have been damaged (more specifically, partially reduced) due to halogen plasma for use to dry-etch a source metal film, thus producing excessive carriers (i.e., decreasing the resistance in the channel).

On the other hand, as shown in FIGS. **8** and **9****,** the thin-film transistors **10** representing Examples #1 and #2 did exhibit the transistor characteristic (ON/OFF characteristic) definitely and their threshold voltage could be controlled to fall within an appropriate range. This is because when the source metal film **20** was dry-etched, the oxide semiconductor layer **13** was not directly exposed to the etching gas, thus preventing excessive carriers from being generated.

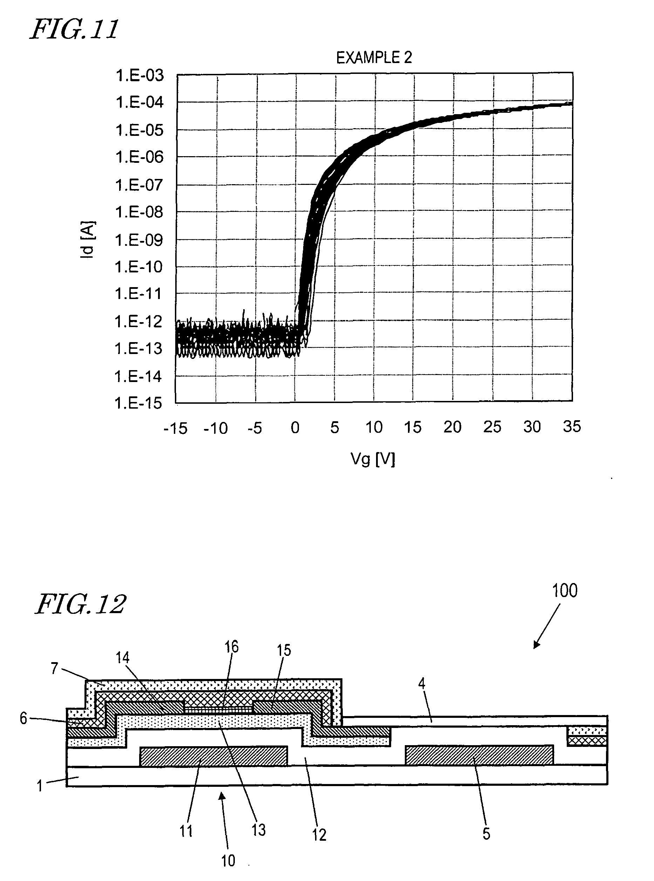

Next, a lot of thin-film transistors **10** according to Example #1 and a lot of thin-film transistors **10** according to Example #2 were made to measure how much their gate voltage-drain current (Vg-Id) characteristics varied. The results of measurements on the thin-film transistors **10** and **20** representing Examples #1 and #2 are shown in FIGS. **10** and **11****,** respectively.

As shown in FIG. **10****,** the thin-film transistor **10** representing Example #1 did exhibit the transistor characteristic definitely but its Vg-Id characteristic varied. This is because when the metal film (source metal film) **20** was formed, a reduction reaction would have occurred in the oxide semiconductor layer **13,** thus depositing metal in the channel region **13c** and making a leakage path.

On the other hand, the thin-film transistor **10** representing Example #2 exhibited less variation in Vg-Id characteristic as shown in FIG. **11****.** The reason is that as the conductor film **20'** (i.e., the metallic compound layer **16**) had a thickness of 1 nm to 5 nm and as the oxide semiconductor layer **13** could be oxidized in the process step of oxidizing the conductor film **20',** it was possible to prevent the metal deposited in the channel region **13c** from making a leakage path.

### (FOUR-MASK PROCESS)

Hereinafter, an example in which the manufacturing process of this embodiment is carried out as a four-mask process will be described. For the purpose of comparison, a known method for fabricating a TFT substrate including a thin-film transistor **10B** with the structure shown in FIG. **15** will also be described.

FIG. **12** illustrates the structure of a TFT substrate **100** to be fabricated in this example. In the TFT substrate **100** shown in FIG. **2****,** the drain electrode **15** is extended to the point that the drain electrode **15** overlaps with the storage capacitor line **5,** and the pixel electrode **4** is connected to the drain electrode **15** at the position where the drain electrode **5** overlaps with the storage capacitor line **5.** On the other hand, in the TFT substrate **100** shown in FIG. **12****,** the drain electrode **15** is not extended to the point that the drain electrode **15** overlaps with the storage capacitor line **5,** and the pixel electrode **4** is connected to the drain electrode **15** at a position where the drain electrode **5** does not overlap with the storage capacitor line **5.**

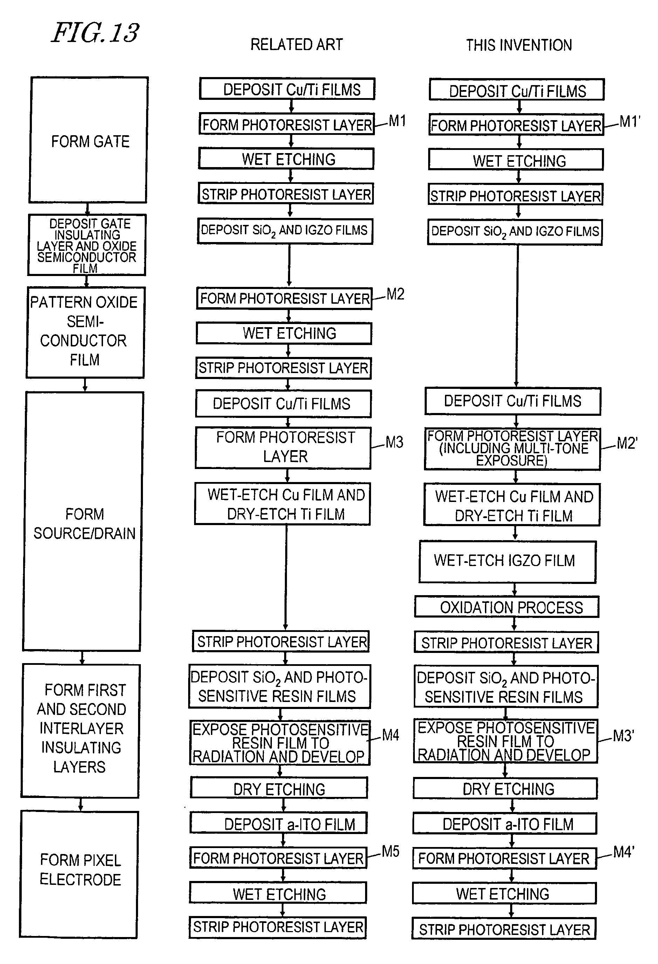

FIG. **13** shows the manufacturing process of this example and a known manufacturing process. In the middle of FIG. **13****,** shown is a detailed flowchart of the known manufacturing process. On the right-hand side of FIG. **13****,** shown is a detailed flowchart of the manufacturing process of this example. And on the left-hand side of FIG. **13****,** shown is a flowchart outlining the known manufacturing process and the manufacturing process of this embodiment. As will be described later, strictly speaking, this outline does not exactly agree with the procedure of the manufacturing process of this example. In FIG. **13****,** shown is an example in which a Cu/Ti film, an SiO₂ film, an IGZO film, a Cu/Ti film, an SiO₂ film and a photosensitive resin film are used as the gate metal film, the gate insulating layer **12,** the oxide semiconductor layer **13,** the source metal film (metal film) **20,** the first interlayer insulating layer **6** and the second interlayer insulating layer **7,** respectively.

To begin with, the known manufacturing process shown in the middle of FIG. **13** will be described.

First, a Cu/Ti film is deposited as a gate metal film on the substrate **1** and then is partially covered with a photoresist layer. Next, the Cu/Ti film is patterned by performing a wet etching process using the photoresist layer as a mask. After that, the photoresist layer is stripped. In this manner, a gate electrode **11,** a gate line and a storage capacitor line are formed.

Subsequently, an SiO₂ film and an IGZO film are deposited in this order as the gate insulating layer **12** and an oxide semiconductor film, respectively.

Next, the oxide semiconductor film is patterned into an oxide semiconductor layer **13** comprised of semiconductor islands. Specifically, first, a photoresist layer is defined so as to partially cover the IGZO film. Next, a wet etching process is carried out using the photoresist layer as a mask and then the photoresist layer is stripped.

Thereafter, a Cu/Ti film is deposited as a source metal film, and then is partially covered with a photoresist layer. Next, the Cu layer is wet-etched using the photoresist layer as a mask, the Ti layer is patterned by dry etching, and then the photoresist layer is stripped. In this manner, a source electrode **14,** a drain electrode **15** and a source line are formed.

Subsequently, an SiO₂ film and a photosensitive resin film are deposited in this order as the first and second interlayer insulating layers, respectively, and then the photosensitive resin film is exposed to radiation and developed, thereby cutting a hole through a part of the photosensitive resin film. After that, by performing a dry etching process using the photosensitive resin film as a mask, a hole is also cut through the SiO₂ film.

Next, an amorphous ITO film is deposited and then is partially covered with a photoresist layer. Subsequently, the amorphous ITO film is patterned by performing a wet etching process using the photoresist layer as a mask, and then the photoresist layer is stripped. In this manner, a pixel electrode is formed.

According to this known manufacturing process, photomasks are used in the five process steps (which are identified by the reference numerals **M1** through **M5** in FIG. **13**), and therefore, five photomasks are needed overall.

Hereinafter, the manufacturing process shown on the right-hand side of FIG. **13** will be described.

First, a Cu/Ti film is deposited as a gate metal film on the substrate **1** and then is partially covered with a photoresist layer. Next, the Cu/Ti film is patterned by performing a wet etching process using the photoresist layer as a mask. After that, the photoresist layer is stripped. In this manner, a gate electrode **11,** a gate line **2** and a storage capacitor line **5** are formed.

Subsequently, an SiO₂ film and an IGZO film are deposited in this order as the gate insulating layer **12** and an oxide semiconductor film, respectively.

Next, a Cu/Ti film is deposited as a source metal film **20** and then is partially covered with a photoresist layer. To form this photoresist layer, a multi-tone exposure process is carried out using a multi-tone mask. Subsequently, using this photoresist layer as a mask, the Cu and Ti layers are patterned by wet etching and by dry etching, respectively, thereby forming a source electrode **14,** a drain electrode **15** and a source line **3.** In this process step, a portion of the source metal film **20** that is located over the channel region **13c** remains as a conductor film **20',** which is thinner than the other portions. Next, by performing a wet etching process (using oxalic acid, for example), the IGZO film is patterned, thereby forming an oxide semiconductor layer **13** comprised of semiconductor islands. Thereafter, the conductor film **20'** on the channel region **13c** is oxidized through an oxidation process, thereby forming a titanium oxide layer as the metallic compound layer **16.** If the conductor film **20'** has a thickness of 1 nm to 5 nm, the oxide semiconductor layer **13** is also oxidized in this process step. Next, the photoresist layer is stripped.

Subsequently, an SiO₂ film and a photosensitive resin film are deposited in this order as the first and second interlayer insulating layers **6** and **7,** respectively, and then the photosensitive resin film is exposed to radiation and developed, thereby cutting a hole through a part of the photosensitive resin film. After that, by performing a dry etching process using the photosensitive resin film as a mask, a hole is also cut through the SiO₂ film.

Next, an amorphous ITO film is deposited and then is partially covered with a photoresist layer. Subsequently, the amorphous ITO film is patterned by performing a wet etching process using the photoresist layer as a mask, and then the photoresist layer is stripped. In this manner, a pixel electrode **4** is formed.

According to the manufacturing process just described, photomasks are used in the four process steps (which are identified by the reference numerals **M1'** through **M4'** in FIG. **13**), and therefore, four photomasks are needed overall. That is to say, the number of masks needed in this process is smaller by one than in the known manufacturing process. According to the manufacturing process of this example, the tact time for defining the source/drain regions becomes longer than in the known process because the additional wet etching and oxidation processes need to be carried out. However, as there is no need to pattern the oxide semiconductor film into islands before depositing the source metal film **20,** the overall throughput increases after all.

In the foregoing description, the present invention is supposed to be applied to a TFT substrate **100** for a liquid crystal display device. However, the present invention can also be used effectively in an active-matrix substrate for an organic EL display device or in an active-matrix substrate for an inorganic EL display device as well.

### INDUSTRIAL APPLICABILITY

The present invention is applicable broadly to various types of devices that use a thin-film transistor. Examples of such devices include circuit boards such as an active-matrix substrate, display devices such as a liquid crystal display, an organic electroluminescence (EL) display, and an inorganic electroluminescence display, image capture devices such as an image sensor, and electronic devices such as an image input device and a fingerprint scanner. The present invention can be used particularly effectively in a liquid crystal display with a big monitor screen.

### REFERENCE SIGNS LIST

- **1**: substrate
- **2**: gate line (scan line)
- **3**: source line (signal line)
- **4**: pixel electrode
- **5**: storage capacitor line
- **6**: first interlayer insulating layer
- **7**: second interlayer insulating layer
- **8**: hole
- **10**: thin-film transistor (oxide semiconductor layer TFT)
- **11**: gate electrode
- **12**: gate insulating layer
- **13**: oxide semiconductor layer
- **13s**: source region
- **13d**: drain region
- **13c**: channel region
- **14**: source electrode
- **15**: drain electrode
- **16**: metallic compound layer
- **20**: metal film (source metal film)
- **20'**: conductor film
- **21**: photoresist layer
- **21a**: first portion of photoresist layer
- **21b**: second portion of photoresist layer
- **100**: TFT substrate (active-matrix substrate)

## Claims

1. A semiconductor device comprising:
a substrate;
a gate electrode which is arranged on the substrate;
a gate insulating layer which has been formed on the gate electrode;
an oxide semiconductor layer which has been formed on the gate insulating layer and which includes a channel region and source and drain regions that interpose the channel region between them;
a source electrode which is electrically connected to the source region;
a drain electrode which is electrically connected to the drain region; and
a metallic compound layer which is arranged between the source and drain electrodes so as to be located on, and contact with, the oxide semiconductor layer,
wherein the metallic compound layer is an insulating layer or semiconductor layer which is made of a compound of the same metallic element as at least one of metallic elements that are included in the source and drain electrodes.

2. The semiconductor device of claim 1, wherein the metallic compound layer is thinner than the source and drain electrodes.

3. The semiconductor device of claim 1 or 2, wherein the metallic compound layer has a thickness of 1 nm to 50 nm.

4. The semiconductor device of claim 3, wherein the metallic compound layer has a thickness of 1 nm to 5 nm.

5. The semiconductor device of one of claims 1 to 4, wherein the metallic compound layer is a metal oxide layer.

6. A method for fabricating a semiconductor device, the method comprising the steps of:
(A) forming a gate electrode on a substrate;
(B) covering the gate electrode with a gate insulating layer;
(C) forming an oxide semiconductor layer on the gate insulating layer; and
(D) providing a source electrode and a drain electrode that are electrically connected to the oxide semiconductor layer,
wherein the step (D) includes the steps of:
(D-1) forming a metal film over the oxide semiconductor layer; and
(D-2) patterning the metal film, thereby forming the source and drain electrodes, and
wherein the step (D-2) of patterning is performed so that a portion of the metal film that is located over a portion of the oxide semiconductor layer to be a channel region remains as a conductor film that is thinner than the source and drain electrodes, and
wherein the method further comprises the step (E) of forming a metallic compound layer between the source and drain electrodes by producing a chemical reaction in the conductor film.

7. The method of claim 6, wherein the step (D-2) includes the steps of:
(D-2-1) forming a photoresist layer which partially covers the metal film and which has a first portion that overlaps with parts of the oxide semiconductor layer to be source and drain regions; and
(D-2-2) etching the metal film using the photoresist layer as a mask.

8. The method of claim 7, wherein the step (D-2-1) is performed so that the photoresist layer has a second portion that overlaps with a part of the oxide semiconductor layer to be a channel region and that is thinner than the first portion.

9. The method of claim 8, wherein the step (D-2-1) includes an exposure process step that uses a multi-tone mask.

10. The method of one of claims 6 to 9, wherein the metallic compound layer formed in the step (E) is either an insulating layer or a semiconductor layer.

11. The method of one of claims 6 to 10, wherein the metallic compound layer has a thickness of 1 nm to 50 nm.

12. The method of claim 11, wherein the metallic compound layer has a thickness of 1 nm to 5 nm.

13. The method of one of claims 6 to 12, wherein the step (E) includes forming a metal oxide layer as the metallic compound layer by oxidizing the conductor film.
